# EUROPEAN PATENT SPECIFICATION

(11) **EP 2 740 340 B1**
(45) Date of publication and mention of the grant of the patent: **30.12.2020**
(21) Application number: 12820084.7
(22) Date of filing: 01.08.2012
(51) Int. Cl.: H05K 9/00, B29C 70/88, B82Y 30/00, H01B 1/24

(54) **A COMPOSITE FOR PROVIDING ELECTROMAGNETIC SHIELDING**
VERBUNDWERKSTOFF FÜR ELEKTROMAGNETISCHE ABSCHIRMUNG
COMPOSITE POUR FOURNIR UN ÉCRAN DE BLINDAGE VIS-À-VIS DU RAYONNEMENT ÉLECTROMAGNÉTIQUE

(30) Priority: 04.08.2011 US 201113198249
(43) Date of publication of application: 11.06.2014
(73) Proprietor: Nokia Technologies Oy, 02610 Espoo (FI)
(72) Inventor: ERMOLOV, Vladimir Alexsandrovich, FI-02130 Espoo (FI); OKSANEN, Markku Anttoni, FIN-00940 Helsinki (FI); CHALAPAT, Khattiya, FI-02150 Espoo (FI); PARAOANU, Gheorghe Sorin, FI-02140 Espoo (FI)
(74) Representative: Swindell & Pearson Limited
(86) International application number: PCT/IB2012/053929
(87) International publication number: WO 2013/018040

(56) References cited:
- WO-A1-2008/055421
- WO-A1-2008/078847
- CN-A- 1 401 562
- CN-A- 101 812 239
- US-A1- 2010 019 209
- US-A1- 2010 021 682
- US-A1- 2011 014 460
- DATABASE CA [Online] CHEMICAL ABSTRACTS SERVICE, COLUMBUS, OHIO, US; 31 March 2006 (2006-03-31), CHEN, JIELIANG: "Anti-electromagnetic interference shell for electronic devices", XP002732533, retrieved from STN Database accession no. 2006:302885 -& CN 1 738 522 A (HONGFUJIN PRECISION INDUSTRY CO., LTD., PEOP. REP. CHINA) 22 February 2006 (2006-02-22)

## Description

### TECHNOLOGICAL FIELD

Embodiments of the present invention relate to a composite for providing electromagnetic shielding.

### BACKGROUND

Electromagnetic shielding has many applications. It may, for example, be used to shield electronic components from radio frequency (RF) electromagnetic radiation or to prevent RF electromagnetic radiation from being radiated from components. This can be particularly important if a radio frequency transmitter such as, for example, a mobile cellular telephone transceiver is in close proximity to other electronic components. WO2008/078847 A1 discloses electromagnetic wave-shielding thermoplastic resin compositions comprising 1 to 30 parts by weight of stainless steel fibers, having a thickness of 4 to 25 micrometers, and 0.01 to 10 parts by weight of carbon nanotubes. CN1738522 A divulges electromagnetic interference shield layers comprising a carbon nanoparticle mixture, a binder, and optionally silver nanoparticles. The carbon nanoparticle mixture consists of carbon nanotubes, carbon nanospheres, and carbon black.

### BRIEF SUMMARY

According to the present invention, which is specified in the appended claims, there is provided a composite for providing electromagnetic shielding comprising: a plurality of elongate nanostructures; and a plurality of elongate conductive elements.

The composite material may, for example, be a thin shell molded into different shapes. It can therefore provide effective electromagnetic shielding without occupying valuable space which is at a premium in a hand-portable electronic apparatus.

### BRIEF DESCRIPTION

For a better understanding of various examples of embodiments of the present invention reference will now be made by way of example only to the accompanying drawings in which:
Fig 1 schematically illustrates a composite for providing electromagnetic shielding;
Fig 2 schematically demonstrates an electromagnetic shielding effect by the composite; and
Fig 3 schematically illustrates an apparatus that uses the composite material for electromagnetic shielding.

### DETAILED DESCRIPTION

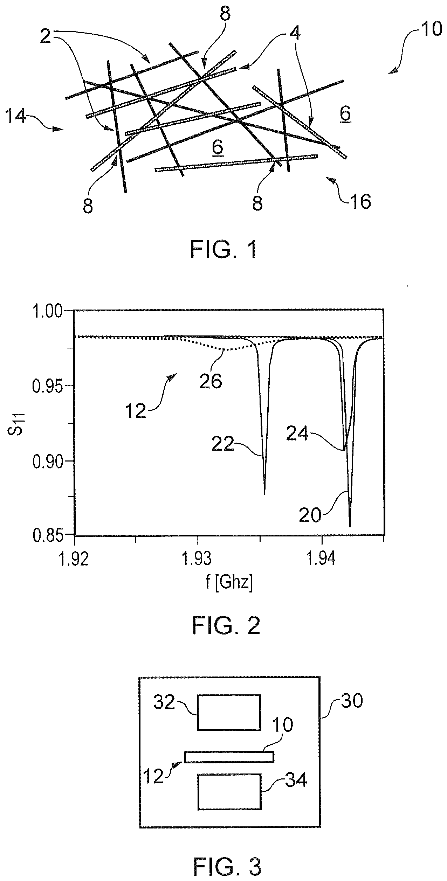

Fig 1 schematically illustrates a composite 10 for providing electromagnetic shielding 12.

The composite 10 comprises a plurality of nanostructures 2 and a plurality of conductive elements 4.

In this example, the plurality of nanostructures are elongate nanostructures 2 and the plurality of conductive elements are elongate conductive elements. Elongate in this sense means that a length is greater than a width. An aspect ratio defined by the ratio of length to width may be, for example, in some embodiments greater than 100 or even 1000 for the elongate nanostructures and/or the elongate conductive elements.

In this example, the plurality of elongate nanostructures 2 and the plurality of elongate conductive elements 4 form an anisotropic mixture 16. That is, in general, neither the plurality of elongate nanostructures 2 nor the plurality of elongate conductive elements 4 are aligned along a particular vector.

In the present disclosure, however, there may be applications where this may be desirable. For example, if a polarization of a radio frequency electromagnetic field is known, alignment relative to the polarization may be desirable. Alignment may, for example, be achieved by applying a strain force and/or an electric field during manufacture.

In the illustrated example, at least some of the plurality of elongate nanostructures 2 and at least some of the plurality of elongate conductive elements 4 contact 8 to form a connected network 14.

The connected network 14 is maintained by a binder that fills at least some of the voids between the plurality of elongate nanostructures 2 and the plurality of elongate conductive elements 4. The binder is a polymer.

The density of elongate nanostructures 2 and the density of elongate conductive elements 4 are selected to control the connectedness of the connected network 14. By increasing the density of elongate nanostructures 2 and the density of elongate conductive elements 4 it is possible to increase the number of contacts 8 between the elongate nanostructures 2 and the elongate conductive elements 4. If the connectedness of the network is defined as the number of network nodes (contacts 8), then as the number of contacts 8 increases the connectedness of the network increases.

It may be desirable to control 'electrical connectedness'. If the connectedness of the network is defined as the number of network nodes (contacts 8), then the 'electrical connectedness' of the network is defined as the number of network nodes that have a lower electrical impedance (lower-impedance contacts 8). For example, a contact 8 between the elongate nanostructures 2 and the elongate conductive elements 4 may form a lower electrical impedance node where the contact electrical impedance is below a particular value or it may form a higher electrical impedance node where the contact electrical impedance is above a particular value. The contact electrical impedance may comprise an electrical resistive component R and /or an electrical reactive component jX The reactive component may include a capacitive component and/or an inductive component. The density and characteristics of elongate nanostructures 2 and the density and characteristics of elongate conductive elements 4 are selected to control the connectedness of the connected network 14 and the contact electrical impedance when they contact.

In the present disclosure, the plurality of elongate nanostructures 2 may consist of a single species (class) of nanostructure.

Alternatively the plurality of elongate nanostructures 2 may consist of a multiple different species (classes) of nanostructure.

A species (class) may be defined in different ways.

For example, 'species' may be defined structurally. In this example, nanostructures of the same species have the same or similar structures. For example they may all be either nanotubes (single walled or multi-wall nanotubes), nanofibers, nanowires or nanotube yarns.

As another example, 'species' may be defined compositionally. In this example, nanostructures of the same species have the same or similar compositions. For example they may all be nanostructures formed from either carbon, boron nitride, silicon carbide, metal or, for example, other materials capable of forming nanotubes.

As another example, 'species' may be defined geometrically. In this example, nanostructures of the same species may be nanotubes that have the same chiral vector.

As another example, 'species' may be defined functionally. In this example, nanostructures of the same species have the same functional features such, for example, conductivity. They may, for example, all be semiconducting or narrow band gap semiconducting or metallic conducting.

It should also be appreciated that a 'species' may be defined using some other common characteristic such as for example length

In addition, a 'species' may be defined using any combination or subcombination of characteristics. For example, a species (class) may be defined structurally and/or compositionally and/or geometrically and/or functionally and/or using length etc.

In the present disclosure, the elongate conductive elements 4 have metallic conductivity. They may be metallic, for example, they may be metal wires. They may also be nanostructures (a nanostructure in this document means a structure having a smallest dimension that is less than 1µm).

The electromagnetic shielding 12 provided by the composite 10 is illustrated in Fig 2. This figure illustrates a reflection spectra for a resonant cavity for different samples.

The trace 20 illustrates a strong resonance when the resonant cavity is empty. The trace 22 illustrates a strong resonance when the resonant cavity comprises a sample comprising only elongate conductive elements 4 (Cu wire that has a width 90 and length 2 cm).

The trace 24 illustrates a strong resonance when the resonant cavity comprises a sample comprising only multi-walled carbon nanotube (MCNT) yarn that has a width 200nm and a length 5mm.

The trace 26 illustrates a very weak resonance when the resonant cavity comprises a sample of the composite 10 which comprises a plurality of elongate nanostructures 2 and a plurality of elongate conductive elements 4 as an anisotropic mixture.

The elongate nanostructures comprise a single species, multi-walled carbon nanotube (MCNT) yarn, that has a width 200nm and a length 5mm. The elongate conductive elements 4 are Cu wire that has a width 90 and length 2 cm.

It is therefore established experimentally that a mix of a plurality of elongate nanostructures 2 and a plurality of elongate conductive elements 4 gives much better shielding efficiency than only a plurality of elongate nanostructures 2 or a plurality of elongate conductive elements 4 at the same concentrations. It will be observed that there is a surprising reduction in the resonance for the heterogeneous combination of the plurality of elongate nanostructures 2 and the plurality of elongate conductive elements 4 (trace 26) when compared with either a sample comprising only the plurality of elongate nanostructures 2 (trace 24) or a sample comprising only the plurality of elongate conductive elements 4 (trace 22).

It is believed that heterogeneous contacts formed between at least some of the plurality of elongate nanostructures 2 and at least some of the plurality of elongate conductive elements 4 provide for the surprising reduction.

For high aspect ratio-filler/ polymer composites several techniques have been developed to better disperse fillers, including in-situ polymerization, solution processing, spin casting and melt spinning. In addition, some processing aids have been used to enhance the dispersion such as sonification, magnetic fields, surfactants and functionalization.

A wide range of polymeric resins, natural or synthetic, may be used as filler in the composite material 10. Suitable synthetic polymeric resins include, but are not limited to, polyethylene, polypropylene, polyvinyl chloride, unsaturated polyesters, etc.

The polymeric materials can contain other ingredients and additives well known in the field of polymers to provide various desirable properties.

The amount of elongate nanostructures 2 and elongate conductive elements 4 in the composite will typically be in the range of 0. 001 to 15 weight percent based on the amount of polymer, for example, 0. 01 to 5 weight percent.

In the present disclosure, the elongate nanostructures 2 and elongate conductive elements 4 are typically dispersed essentially homogeneously throughout the bulk of the polymeric material but can also be present in gradient fashion, increasing or decreasing in amount (e. g. concentration) from the external surface toward the middle of the material or from one surface to another, etc.

The amount of elongate nanostructures 2 will be chosen to be effective for the desired electromagnetic shielding.

Electromagnetic shielding has many applications. Fig 3 schematically illustrates an apparatus 30 where composite material 10 is used to provide electromagnetic shielding from a source 32 of electromagnet radiation and electronic components 34. In this example, the source is internal to the apparatus 30 in other examples not illustrated the source 32 may be outside the apparatus 30.

The electromagnetic radiation may be, for example, radio frequency (RF) electromagnetic radiation. For example the source 32 may be a radio frequency transmitter such as, for example, a mobile cellular telephone transceiver that is in close proximity to electronic component(s) 34.

The composite material may, for example, be a thin shell molded into different shapes. It can therefore provide effective electromagnetic shielding without occupying valuable space which is at a premium in a hand-portable electronic apparatus.

Although embodiments of the present invention have been described in the preceding paragraphs with reference to various examples, it should be appreciated that modifications to the examples given can be made without departing from the scope of the invention as claimed.

Features described in the preceding description may be used in combinations other than the combinations explicitly described.

Although functions have been described with reference to certain features, those functions may be performable by other features whether described or not.

Although features have been described with reference to certain embodiments, those features may also be present in other embodiments whether described or not.

## Claims

1. A composite for providing electromagnetic shielding comprising:
a plurality of elongate nanostructures consisting of carbon nanotube yarns;
a plurality of elongate metallic nanostructures; and
a binder, wherein the binder is a polymeric material;
wherein the plurality of elongate nanostructures and the plurality of elongate metallic nanostructures are dispersed essentially homogeneously throughout the bulk of the polymeric material;
wherein neither the plurality of elongate nanostructures nor the plurality of elongate metallic nanostructures are aligned along a particular vector.

2. A composite as claimed in claim 1, wherein at least some of the plurality of elongate nanostructures and at least some of the plurality of elongate conductive elements contact to form an electrically connected network.

3. A composite as claimed in claim 2, wherein the density of elongate nanostructures and the density of elongate conductive elements are selected to control the connectedness of the electrically connected network.

4. A composite as claimed in any of the preceding claims, wherein a species of nanostructures have the same length and wherein different species of nanostructures have different lengths.

5. A composite as claimed in any of the preceding claims, wherein a species of nanostructures have the same conductivity and wherein different species of nanostructures have different conductivity.

6. A composite as claimed in any of the preceding claims, wherein the polymeric material is a polymeric resin selected from: polyethylene; polypropylene; polyvinyl chloride; and unsaturated polyesters.

7. A method comprising:
mixing a plurality of elongate nanostructures consisting of carbon nanotube yarns and a plurality of elongate metallic nanostructures with at least one other material to form a composite for providing electromagnetic shielding, wherein the at least one other material comprises a binder, wherein the binder is a polymeric material;
wherein the plurality of elongate nanostructures and the plurality of elongate metallic nanostructures are dispersed essentially homogeneously throughout the bulk of the polymeric material;
wherein neither the plurality of elongate nanostructures nor the plurality of elongate metallic nanostructures are aligned along a particular vector.

8. A method as claimed in claim 7 wherein the amount of elongate nanostructures and elongate metallic nanostructures is between 0.001 to 15 percent, by mass, of the at least one other material.

## Patentansprüche

1. Verbundmaterial zum Bereitstellen von elektromagnetischer Abschirmung, das umfasst:
eine Vielzahl von länglichen Nanostrukturen, die aus Kohlenstoff-Nanoröhrchengarnen bestehen;
eine Vielzahl von länglichen metallischen Nanostrukturen; und
ein Bindemittel, wobei das Bindemittel ein Polymermaterial ist;
wobei die Vielzahl von länglichen Nanostrukturen und die Vielzahl von länglichen metallischen Nanostrukturen im Wesentlichen homogen über die gesamte Masse des Polymermaterials verteilt sind;
wobei weder die Vielzahl von länglichen Nanostrukturen noch die Vielzahl von länglichen metallischen Nanostrukturen entlang eines bestimmten Vektors ausgerichtet sind.

2. Verbundmaterial nach Anspruch 1, wobei mindestens einige von der Vielzahl von länglichen Nanostrukturen und mindestens einige von der Vielzahl von länglichen leitfähigen Elementen sich kontaktieren, um ein elektrisch verbundenes Netz zu bilden.

3. Verbundmaterial nach Anspruch 2, wobei die Dichte der länglichen Nanostrukturen und die Dichte der länglichen leitfähigen Elemente ausgewählt sind, um die Verbundenheit des elektrisch verbundenen Netzes zu steuern.

4. Verbundmaterial nach einem der vorhergehenden Ansprüche, wobei eine Spezies von Nanostrukturen die gleiche Länge aufweist und wobei unterschiedliche Spezies von Nanostrukturen unterschiedliche Längen aufweisen.

5. Verbundmaterial nach einem der vorhergehenden Ansprüche, wobei eine Spezies von Nanostrukturen die gleiche Leitfähigkeit aufweist und wobei unterschiedliche Spezies von Nanostrukturen unterschiedliche Leitfähigkeiten aufweisen.

6. Verbundmaterial nach einem der vorhergehenden Ansprüche, wobei das Polymermaterial ein Polymerharz ist, das ausgewählt ist aus: Polyethylen; Polypropylen; Polyvinylchlorid; und ungesättigten Polyestern.

7. Verfahren, das umfasst:
Mischen einer Vielzahl von länglichen Nanostrukturen, die aus Kohlenstoff-Nanoröhrchengarnen und einer Vielzahl von länglichen metallischen Nanostrukturen bestehen, mit mindestens einem anderen Material, um ein Verbundmaterial zum Bereitstellen elektromagnetischer Abschirmung zu bilden, wobei das mindestens eine andere Material ein Bindemittel umfasst, wobei das Bindemittel ein Polymermaterial ist;
wobei die Vielzahl von länglichen Nanostrukturen und die Vielzahl von länglichen metallischen Nanostrukturen im Wesentlichen homogen über die gesamte Masse des Polymermaterials verteilt sind;
wobei weder die Vielzahl von länglichen Nanostrukturen noch die Vielzahl von länglichen metallischen Nanostrukturen entlang eines bestimmten Vektors ausgerichtet sind.

8. Verfahren nach Anspruch 7, wobei die Menge an länglichen Nanostrukturen und länglichen metallischen Nanostrukturen zwischen 0,001 und 15 Massenprozent des mindestens einen anderen Materials beträgt.

## Revendications

1. Composite pour réaliser un blindage électromagnétique, comprenant :
une pluralité de nanostructures allongées constituées de fils de nanotubes de carbone ;
une pluralité de nanostructures métalliques allongées ; et
un liant, le liant étant un matériau polymère ;
dans lequel la pluralité de nanostructures allongées et la pluralité de nanostructures métalliques allongées sont dispersées de manière pratiquement homogène dans toute la masse du matériau polymère ;
dans lequel ni la pluralité de nanostructures allongées ni la pluralité de nanostructures métalliques allongées ne sont alignées le long d'un vecteur particulier.

2. Composite selon la revendication 1, dans lequel au moins certaines parmi la pluralité de nanostructures allongées et au moins certains parmi la pluralité d'éléments conducteurs allongés viennent en contact pour former un réseau électriquement connecté.

3. Composite selon la revendication 2, dans lequel la densité des nanostructures allongées et la densité des éléments conducteurs allongés sont choisies de façon à contrôler la connexité du réseau électriquement connecté.

4. Composite selon l'une quelconque des revendications précédentes, dans lequel une espèce de nanostructures a la même longueur et dans lequel des espèces différentes de nanostructures ont des longueurs différentes.

5. Composite selon l'une quelconque des revendications précédentes, dans lequel une espèce de nanostructures a la même conductivité et dans lequel des espèces différentes de nanostructures ont des conductivités différentes.

6. Composite selon l'une quelconque des revendications précédentes, dans lequel le matériau polymère est une résine polymère choisie parmi : le polyéthylène ; le polypropylène ; le poly(chlorure de vinyle) ; et les polyesters insaturés.

7. Procédé comprenant :
le mélange d'une pluralité de nanostructures allongées constituées de fils de nanotubes de carbone et d'une pluralité de nanostructures métalliques allongées avec au moins un autre matériau pour former un composite pour réaliser un blindage électromagnétique,
dans lequel le au moins un autre matériau comprend un liant, le liant étant un matériau polymère ;
dans lequel la pluralité de nanostructures allongées et la pluralité de nanostructures métalliques allongées sont dispersées de manière pratiquement homogène dans toute la masse du matériau polymère ;
dans lequel ni la pluralité de nanostructures allongées ni la pluralité de nanostructures métalliques allongées ne sont alignées le long d'un vecteur particulier.

8. Procédé selon la revendication 7, dans lequel la quantité de nanostructures allongées et de nanostructures métalliques allongées est comprise entre 0,001 et 15 % en masse du au moins un autre matériau.
